# FASCICULE DE BREVET EUROPEEN

(11) **EP 4 329 119 B1**
(45) Date de publication et mention de la délivrance du brevet: **25.03.2026**
(21) Numéro de dépôt: 23192803.7
(22) Date de dépôt: 22.08.2023
(51) Int. Cl.: H02G 1/06, H02G 3/30, H02G 3/32, G01R 11/04, G01R 22/06

(54) **DISPOSITIF POUR LE BLOCAGE D'AU MOINS UN FIL ÉLECTRIQUE ET/OU D'AU MOINS UN CÂBLE SUR UN SUPPORT DANS UN BOÎTIER**
VORRICHTUNG ZUM VERRIEGELN MINDESTENS EINES ELEKTRISCHEN DRAHTES UND/ODER MINDESTENS EINES KABELS AUF EINEM TRÄGER IN EINEM GEHÄUSE
DEVICE FOR LOCKING AT LEAST ONE ELECTRIC WIRE AND/OR AT LEAST ONE CABLE TO A SUPPORT IN A HOUSING

(30) Priorité: 23.08.2022 FR 2208463
(43) Date de publication de la demande: 28.02.2024
(73) Titulaire: Sagemcom Energy & Telecom SAS, 92270 Bois-Colombes (FR)
(72) Inventeur: BROSSARD, Matthieu, 92500 RUEIL- MALMAISON (FR)
(74) Mandataire: Regimbeau

(56) Documents cités:
- DE-B- 1 100 747
- FR-A- 1 233 576
- GB-A- 972 995
- JP-A- 2011 188 599
- US-A- 3 066 902
- US-A- 3 252 677
- US-A- 4 781 255
- US-A- 4 936 530
- US-A1- 2021 151 970

## Description

### DOMAINE TECHNIQUE

L'invention concerne un dispositif et un procédé pour le blocage d'au moins un câble et/ou fil électrique sur un support, notamment afin de lui faire suivre un tracé particulier ou éviter qu'il ne vienne dans certaines zones non désirées.

Elle trouve notamment, mais non limitativement application, pour le blocage de fils ou câbles dans des boitiers de compteurs communicants.

### ETAT DE LA TECHNIQUE

Dans plusieurs produits électroniques, comme les compteurs communicants, il est parfois nécessaire de maintenir ou contraindre selon un tracé un ou plusieurs fils électriques (ou des câbles regroupant plusieurs fils). En effet, la présence de fils ou câbles dans certaines zones peut engendrer différentes problématiques : coincements de pièces dans le boitier, obstructions de zones auxquelles il est nécessaire de pouvoir accéder, perturbation de l'émission ou de la réception des antennes du boitier.

On connait classiquement de nombreuses solutions pour le maintien de fils ou de câbles.

Une solution consiste en des clipsages sur des contre-dépouilles moulées d'une pièce avec un support (paroi du boîtier par exemple).

Ces contre-dépouilles sont obtenues grâce à un démoulage à tiroirs, ce qui induit une augmentation du coût de fabrication. Dans certains cas en outre, la complexité de la pièce et/ou du moule rend l'utilisation de tiroirs impossible.

On connait également des clips serre-câbles destinés à être rapportés sur les parois des boitiers. Ces clips, souvent en plastique, sont par exemple collés ou vissés. Ils sont très efficaces pour le maintien en position des fils ou câbles. Mais ces solutions sont très encombrantes ce qui est problématique, notamment dans le domaine des compteurs où la compacité est nécessaire.

Il est également possible de maintenir les fils ou câbles par vissage. Mais cela implique une étape supplémentaire, qui allonge le temps de fabrication et nécessite au moins une pièce supplémentaire pour venir coincer le fil. L'encombrement ainsi que le temps de fabrication n'y sont donc pas optimisés.

Une autre solution encore consiste à coincer le fil dans une paroi en chicane. La chicane peut être démoulée sans tiroir et ce mode de fixation ne nécessite pas de pièce supplémentaire. Mais le maintien en position du fil dans la chicane n'est pas efficace. Le fil peut facilement en sortir et ne plus être contraint dans ses déplacement. Or il est nécessaire que les fils soient maintenus durablement en position car les opérations de maintenance doivent être évitées. En outre, DE1100747B divulgue un dispositif de fixation amovible pour fils électriques dans un canal d'un corps de support, utilisant un élément en plastique inséré dans un alésage. Ce dispositif permet une fixation réversible et facilite la maintenance, mais ne décrit pas une intégration permanente des composants dans le boîtier.

### EXPOSE DE L'INVENTION

L'invention propose de pallier au moins un de ces inconvénients.

A cet effet, l'invention propose, selon un premier aspect, un boîtier de compteur communicant comprenant un support et un dispositif pour le blocage d'au moins un fil électrique et/ou d'au moins un câble sur le support, caractérisé en ce qu'il comprend :
une base solidaire du support
un pion faisant saillie depuis la base,
au moins une paroi faisant saillie depuis la base et s'étendant en regard de ce pion, le support, la base, le pion et la paroi étant moulés d'une pièce avec au moins une paroi du boîtier, et
la base, le pion et la paroi délimitant entre eux un passage propre à être traversé par un fil(s) électrique(s) et/ou câble(s) à bloquer ;
une rondelle autobloquante à griffes adaptée pour s'engager sur le pion et se bloquer mécaniquement entre le pion et la paroi(s) afin de retenir, par rapport à la base et au support, un et/ou fil(s) électrique(s) et/ou câbles préalablement positionnés dans le passage.

L'invention, selon un premier aspect, est avantageusement complétée par les caractéristiques suivantes, prises seules ou en une quelconque de leur combinaison techniquement possible :
- les griffes de la rondelle autobloquante sont des griffes internes adaptées pour s'ancrer sur le pion ;
- les griffes de la rondelle autobloquante sont conformées avec une forme tronconique, qui facilite un pré-positionnement de ladite rondelle autobloquante sur le pion ;
- le pion comprend un chanfrein pour faciliter le pré-positionnement de la rondelle autobloquante sur le pion
- une paroi présente une surface en regard du pion qui est de forme et de dimensions complémentaires à celles de la rondelle autobloquante, ladite paroi participant au guidage et au maintien de la rondelle autobloquante ;
- plusieurs parois s'étendent en saillie depuis la base, lesdites parois délimitant chacune, entre elle-même et le pion, un passage propre à être traversé par un fil(s) électrique(s) et/ou câble(s)
- le pion est de forme creuse ;

L'invention concerne également selon un deuxième aspect, un procédé de blocage d'au moins un fil électrique et/ou d'au moins un câble sur un support de boitier tel que précédemment décrit, le procédé comprenant les étapes suivantes :
(E1) insertion d'au moins un fil électrique et/ou d'au moins un câble dans un passage défini par la base, le pion et une paroi du dispositif ;
(E2) pré-positionnement de la rondelle autobloquante sur le pion ;
(E3) engagement de la rondelle autobloquante sur le pion jusqu'à une position de blocage.

L'invention, selon le deuxième aspect, est avantageusement complétée par les caractéristiques suivantes, prises seules ou en une quelconque de leur combinaison techniquement possible :
- l'engagement de la rondelle autobloquante en position de blocage est réalisée au moyen d'un outil d'insertion adapté pour pousser l'élément autobloquant sur le pion ;
- l'outil d'insertion comprend une jupe dont les rebords assurent la poussée de la rondelle autobloquante lors de son engagement sur le pion et, définissant une cavité avec un fond adapté pour venir en butée contre l'extrémité du pion opposée à la base, la hauteur dudit fond dans ladite jupe étant dimensionnée de manière que la position de blocage dans laquelle la rondelle autobloquante est poussée, laisse un fil(s) électrique(s) et/ou câble(s) libre(s) de coulisser avec un degré de liberté à l'intérieur du passage, ledit fond venant en butée du pion avant que la rondelle autobloquante n'arrive au contact du fil(s) et/ou câble(s) ;
- la rondelle autobloquante entre en contact avec un fil(s) électrique(s) et/ou câble(s), ledit fil(s) électrique(s) et/ou câble(s) étant maintenu(s) fixement à l'intérieur du passage par la rondelle autobloquante.

Les avantages de l'invention sont multiples.

L'encombrement est réduit et le maintien en position est efficace.

De plus, la solution ne possède pas de formes en contre-dépouilles ce qui permet un démoulage simple, sans mouvements supplémentaires ni tiroirs. Sa mise en oeuvre en production est facilitée et économique. Le procédé de moulage est simplifié, le moule utilisé étant un unique moule pour le boitier et le support. Le moule utilisé ne nécessite pas la présence de tiroirs.

En outre, ce dispositif permet de maintenir en position des fils de différentes formes et différentes tailles.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- la figure 1 illustre un dispositif selon un mode de réalisation de la présente invention ;
- la figure 2 illustre un support du dispositif selon un mode de réalisation de la présente invention ;
- la figure 3 illustre un élément autobloquant selon un mode de réalisation de la présente invention ;
- la figure 4 illustre un support du dispositif selon un autre mode de réalisation ;
- la figure 5 illustre une vue en coupe du dispositif selon différentes étapes d'un procédé de blocage de fil selon un mode de réalisation de la présente invention ;
- la figure 6 illustre un boitier comprenant un support selon un mode de réalisation.

Sur l'ensemble des figures les éléments similaires portent des références identiques.

### DESCRIPTION DETAILLEE

Les boitiers électriques, et plus particulièrement les boitiers des compteurs communicants, peuvent intégrer de nombreux fils ou câbles pour le raccordement de leurs différents modules électroniques, la communication entre ceux-ci, leur alimentation, etc... Ces fils ou câbles peuvent être des fils électriques individuels (conducteurs électriques avec enveloppe de protection isolante), des regroupements de fils électriques (torsadés, tressés, soudés, etc.), des câbles regroupant différents fils électriques dans une même gaine, des câbles à fibres optiques, etc....

La fixation des fils et câbles doit être réalisée de façon à ce que ceux-ci soient maintenus en position de manière durable et de manière compacte.

### Exemple de réalisation d'un dispositif de blocage

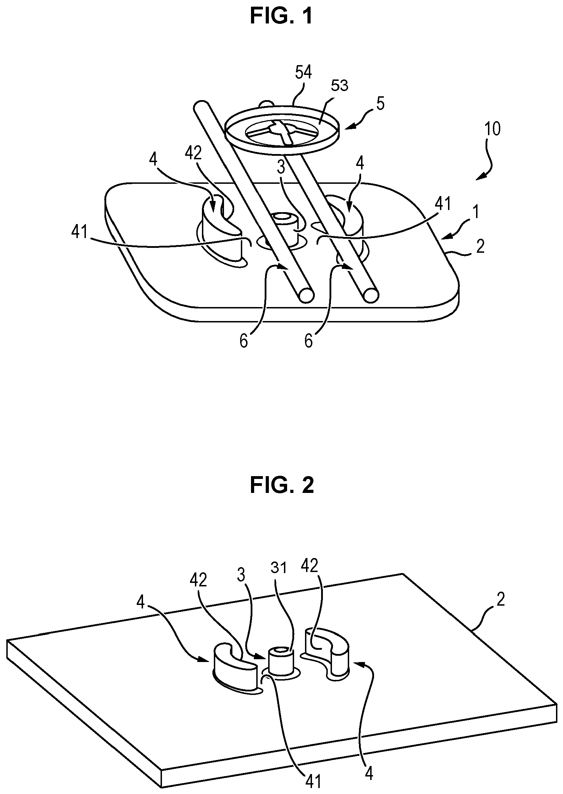

Comme l'illustrent les figures 1 à 3, afin de réaliser cette fonction de maintien sur un support 1 donné, on utilise un ou plusieurs dispositifs de blocage 10, qui vont définir ensemble un chemin de positionnement pour le fil ou le câble. Un tel dispositif 10 comprend une base 2, le cas échéant confondue avec le support 1, ainsi qu'un pion 3 et au moins une paroi 4, chacun en saillie depuis la base 2.

La base 2, le pion 3 et la paroi 4 délimitent entre eux un passage 41. Ce passage 41 est adapté pour être traversé par un fil électrique ou un câble 6, c'est-à-dire que le passage 41 est suffisamment large pour permettre à un fil ou câble 6 que l'on veut bloquer de le traverser de manière linéaire.

Dans l'exemple illustré sur les figures, le dispositif 10 comprend deux parois 4 diamétralement opposées. Un nombre plus important de parois 4 est bien entendu envisageable pour créer différents cheminements possibles pour les fils et câbles 6.

Le dispositif 10 comprend en outre une élément autobloquant 5, telle qu'une rondelle autobloquante, susceptible d'être engagé sur le pion 3 (via un orifice 51). Sa forme et ses dimensions externes sont complémentaires de celles des surfaces 42 des parois 4, lesdites paroi 4 participant au guidage et/ou au maintien de l'élément autobloquant 5 sur le dispositif 10.

Tel qu'illustré par la figure 1, les surfaces 42 des parois 4 qui sont directement en regard du pion 3 sont en arc de cylindre, d'autres géométries étant bien entendu possibles selon la forme de l'élément autobloquant 5. Notamment, dans le cas d'une rondelle autobloquante 5 de forme carrée, les surfaces 42 peuvent être planes pour encadrer les côtés de la rondelle 5 ou être constitués de deux plans en angle droit pour recevoir les coins des rondelles.

Lorsqu'il est dans une position engagée sur le pion 3 et bloqué mécaniquement entre le pion 3 et la ou les parois 4, l'élément autobloquant 5 recouvre au moins une section du passage 41, ce qui permet de bloquer un fil ou câble 6 qui aurait été préalablement positionné dans ledit passage 41 en l'empêchant de se désengager du passage 41.

Le pion 3 est avantageusement cylindrique mais peut être d'une autre forme comme par exemple parallélépipédique.

Selon un mode de réalisation, l'élément autobloquant 5 est une rondelle à griffes, notamment une rondelle présentant une succession de griffes internes 52 s'étendant à partir d'une même couronne annulaire externe 53. Les extrémités des griffes 52 définissent ensemble l'orifice 51 de la rondelle 5. Elles sont dimensionnées et conformées pour s'ancrer, par leurs extrémités libres, sur le pion 3 lorsque ladite rondelle 5 est engagée et poussée sur celui-ci.

Par exemple, les griffes 52 sont des griffes plates et leurs extrémités sont conformées en arc de cercle.

Lesdites griffes 52 sont en outre conformées avec des propriétés mécaniques qui leur permet une élasticité de déformation lors de la mise en place de la rondelle 5 sur le pion 3, deux griffes 52 successives étant séparées entre elles par des fentes traversant l'épaisseur de la rondelle 5.

En outre, lorsque la rondelle 5 n'est pas sollicitée, lesdites griffes 52 définissent ensemble une forme tronconique, qui facilite un pré-positionnement de ladite rondelle 5 sur le pion 3. L'orientation de la partie tronconique de la rondelle 5 formée par les griffes 52 définit une face externe 54 et une face interne 55 et de la rondelle 5.

Également, et comme cela est également visible sur la figure 1, le pion 3 comprend un chanfrein 31 à son extrémité. Le pré-positionnement de la rondelle autobloquante 5 sur le pion 3 est facilité par la présence du chanfrein 31 du pion 3 sur lequel la partie interne 55 de la rondelle autobloquante 5 vient en contact.

D'autres types d'élément autobloquant peuvent néanmoins être utilisé, l'ancrage pouvant être réalisé tant sur le pion 3 que sur la ou les parois 4 du dispositif 10, ou encore sur les deux. Notamment, dans un autre mode de réalisation, un élément autobloquant 5 est un anneau plat à déformation élastique, susceptible d'être comprimé diamétralement sur lui-même lors de la mise en place sur le pion 3, pour être ensuite relâché pour ancrage sur la ou les parois 4.

Les dimensions du pion 3 et des parois 4 sont bien entendu fonction du type de fils ou de câbles 6 que l'on veut bloquer.

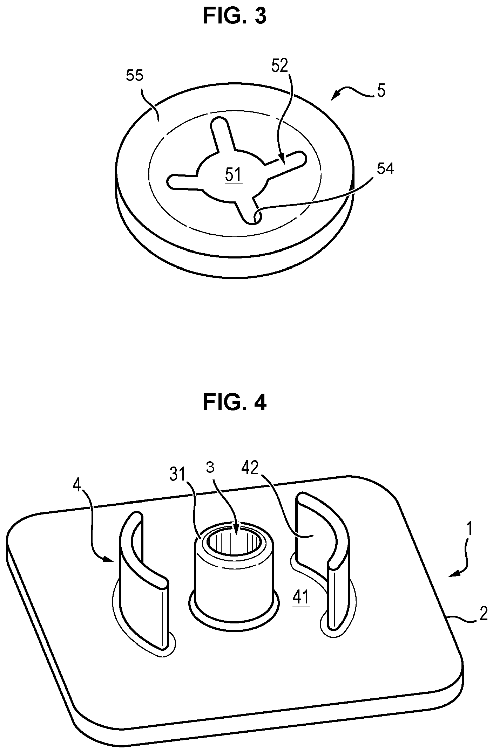

Dans le cas où le pion 3 doit présenter un diamètre important, supérieur à l'épaisseur du support 1, le pion 3 est par exemple un cylindre creux dont l'épaisseur de paroi est égale à l'épaisseur du support 1 et de la ou des parois 4. Ce mode de réalisation, illustré par la figure 4, permet d'éviter un phénomène de retassure dans le cas d'une épaisseur du pion 3 trop importante.

L'élément autobloquant 5 peut quant à lui être un élément standard en matériaux plastique ou acier. Une rondelle autobloquante 5 du type de celle décrite est par exemple réalisée par emboutissage.

### Exemple de mise en œuvre

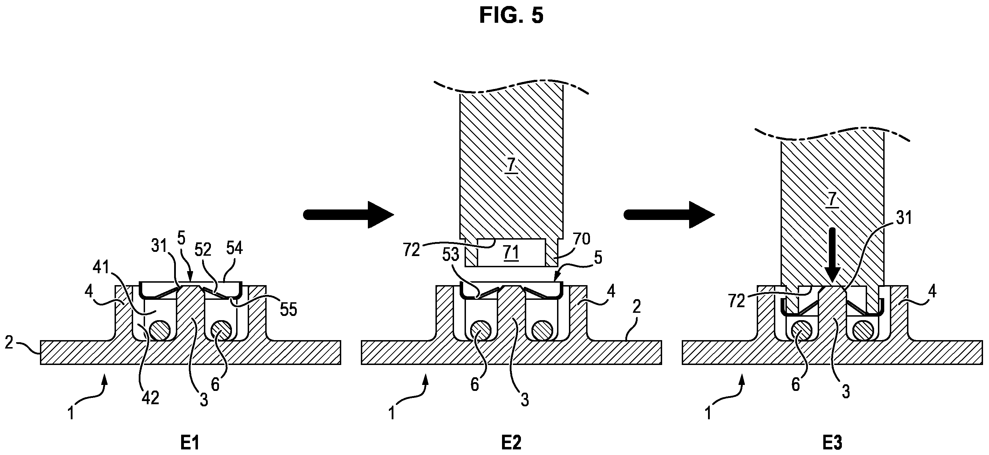

Un exemple de blocage de fils ou câbles 6 est illustré par la figure 5.

Dans une première étape E1, au moins un fil ou un câble 6 est mis en place dans un passage 41 formé par la base 2, le pion 3 et au moins une paroi 4. Selon le nombre de parois 4 et selon les cheminements que l'on veut organiser pour les fils ou câbles, des fils et/ou câbles 6 peuvent être positionnés dans plusieurs passages 41 d'un même dispositif 10.

Dans une deuxième étape E2, l'élément autobloquant 5 est pré-positionné sur le pion 3. Le pré-positionnement est facilité par le chanfrein 31 du pion 3 et par la forme tronconique formée par l'ensemble des griffes 52. Dans le cas d'une rondelle autobloquante 5 du type de celle décrite, la partie interne 55 de la rondelle autobloquante 5 formée par les griffes 52 est en contact avec le chanfrein 31 du pion 3. Suite à cette étape E2 de pré-positionnement, la rondelle autobloquante 5 recouvre les passages 41 entre les parois 4 et le pion 3.

Dans une troisième étape E3 l'élément autobloquant 5 engagé sur le pion 3 est poussé sur celui-ci afin de venir se bloquer mécaniquement en position de blocage entre le pion 3 et la (ou les) paroi(s) 4.

Dans le cas de la rondelle autobloquante 5 décrite ci-dessus, le positionnement en position de blocage sur le pion 3 est irréversible du fait de la présence des griffes 52 qui sont adaptées pour entrer en contact avec le pion 3. Une fois positionnée, la rondelle autobloquante 5 ne peut pas être retirée du pion 3 sans endommager le dispositif 10.

De manière avantageuse, un outil 7 d'insertion est utilisé pour positionner l'élément autobloquant 5 en position de blocage. Typiquement, l'outil 7 vient exercer une pression sur la couronne 53 de la rondelle autobloquante 5. Cette outil 7 d'insertion comprend préférentiellement une jupe 70, dont le bord sert à pousser l'élément autobloquant. Cette jupe 70 délimite une cavité 71 avec un fond 72 venant en butée contre l'extrémité du pion 3 afin de ne pas pincer les fils ou câbles 6 et de les laisser de libres de coulisser dans le ou les passages 41.

De cette manière, un ou des fils (et ou câble(s)) 6 sont
- soit maintenu(s) fixement dans le (ou les) passage(s) 41 si la rondelle autobloquante 5 entre en contact avec un (ou plusieurs des) fil(s)/câbles 6 avant que le fond 72 de la cavité 71 ne vienne en butée contre l'extrémité du pion 3,
- soit laissé(s) coulissant avec un degré de liberté dans le (ou les) passages 41 si la rondelle autobloquante 5 vient en butée contre l'extrémité du pion 3 avant d'entrer en contact avec le (ou les) fil(s)/câble(s) 6.

Pour un même dispositif 10, différents dimensionnements d'outils et de profondeur pour le fond 72 sont envisageables. De cette manière, il est possible de s'adapter aux dimensions des fils et câbles 6 que l'on veut positionner dans les passages 41.

Selon un autre mode de mise en oeuvre et en fonction de la structure de l'élément autobloquant 5, celui-ci peut être positionné dans une position de blocage sur le pion 3 d'une manière différente, comme par exemple par frettage.

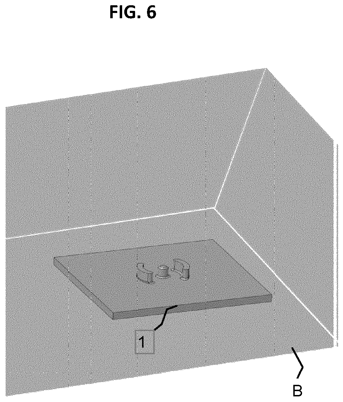

Selon l'invention, le support 1, la base 2 le pion 3 et la ou les parois 4 sont moulés d'une pièce avec au moins une paroi d'un boitier B, ladite paroi constituant une base 2 pour le dispositif, comme illustré par la figure 6.

Le support 1 peut être une paroi du boitier B, par exemple une paroi d'un boitier de compteur intelligent. La base 2 peut elle-même être confondue avec cette paroi.

Ainsi, le moulage de la base 2, du pion 3 et de la ou des parois 4 se fait dans le cadre du moulage du boitier B, un seul et unique moule permettant de fabriquer le boitier B avec un tel support 1. Le moule permettant d'obtenir le boitier B avec le support 1 est un moule simple sans tiroirs, ce qui facilite la production.

## Revendications

1. Boîtier (B) de compteur communicant comprenant un support (1) et un dispositif (10) pour le blocage d'au moins un fil électrique et/ou d'au moins un câble (6) sur le support (1), qui comprend :
- une base (2) solidaire du support (1),
- un pion (3) faisant saillie depuis la base (2),
- au moins une paroi (4) faisant saillie depuis la base (2) et s'étendant en regard de ce pion (3),
le support (1), la base (2), le pion (3) et la paroi (4) étant moulés d'une pièce avec au moins une paroi du boitier (B), et la base (2), le pion (3) et la paroi (4) délimitant entre eux un passage (41) propre à être traversé par un (ou des) fil(s) électrique(s) et/ou câble(s) (6) à bloquer ;
- une rondelle autobloquante (5) à griffes (52) adaptée pour s'engager sur le pion (3) et se bloquer mécaniquement entre le pion (3) et la (ou les) paroi(s) (4) afin de retenir, par rapport à la base (2) et au support (1), un (ou des) et/ou fil(s) électrique(s) et/ou câbles (6) préalablement positionnés dans le passage (41).

2. Boîtier (B) de compteur communicant selon la revendication 1, dans lequel les griffes (52) de la rondelle autobloquante (5) sont des griffes (52) internes adaptées pour s'ancrer sur le pion (3).

3. Boîtier (B) de compteur communicant selon l'une des revendications 1 à 2, dans lequel les griffes (52) de la rondelle autobloquante (5) sont conformées avec une forme tronconique, qui facilite un pré-positionnement de ladite rondelle autobloquante (5) sur le pion (3).

4. Boîtier (B) de compteur communicant selon l'une des revendication 1 à 3, dans lequel le pion (3) comprend un chanfrein (31) pour faciliter le pré-positionnement de la rondelle autobloquante (5) sur le pion (3).

5. Boîtier (B) de compteur communicant selon l'une des revendication 1 à 4, dans lequel une paroi (4) présente une surface (42) en regard du pion (3) qui est de forme et de dimensions complémentaires à celles de la rondelle autobloquante (5), ladite paroi (42) participant au guidage et au maintien de la rondelle autobloquante (5).

6. Boîtier (B) de compteur communicant selon l'une des revendications 1 à 5, dans lequel plusieurs parois (4) s'étendent en saillie depuis la base (2), lesdites parois (4) délimitant chacune, entre elle-même et le pion (3), un passage (41) propre à être traversé par un (ou des) fil(s) électrique(s) et/ou câble(s) (6).

7. Boîtier (B) de compteur communicant selon l'une des revendication 1 à 6, dans lequel le pion (3) est de forme creuse.

8. Boîtier (B) de compteur communicant selon l'une quelconque des revendications 1 à 7, dans lequel ladite paroi du boîtier constituant une base (2) pour le dispositif (10).

9. Procédé de blocage d'au moins un fil électrique et/ou d'au moins un câble (6) sur un support (1) de boitier (B) selon l'une des revendications 1 à 8, le procédé comprenant les étapes suivantes :
- (E1) insertion d'au moins un fil électrique et/ou d'au moins un câble (6) dans un passage (41) défini par la base (2), le pion (3) et une paroi (4) du dispositif ;
- (E2) pré-positionnement de la rondelle autobloquante (5) sur le pion (3) ;
- (E3) engagement de la rondelle autobloquante (5) sur le pion (3) jusqu'à une position de blocage.

10. Procédé de blocage selon la revendication 9, dans lequel l'engagement de la rondelle autobloquante (5) en position de blocage est réalisée au moyen d'un outil (7) d'insertion adapté pour pousser l'élément autobloquant sur le pion (3).

11. Procédé de blocage selon la revendication 10, dans lequel l'outil (7) d'insertion comprend une jupe dont les rebords assurent la poussée de la rondelle autobloquante (5) lors de son engagement sur le pion (3) et, définissant une cavité (71)avec un fond (72) adapté pour venir en butée contre l'extrémité du pion (3) opposée à la base (2), la hauteur dudit fond (72) dans ladite jupe (70) étant dimensionnée de manière que la position de blocage dans laquelle la rondelle autobloquante (5) est poussée, laisse un (ou des) fil(s) électrique(s) et/ou câble(s) (6) libre(s) de coulisser avec un degré de liberté à l'intérieur du passage (41), ledit fond (72) venant en butée du pion (3) avant que la rondelle autobloquante (5) n'arrive au contact du (ou des) fil(s) et/ou câble(s).

12. Procédé de blocage selon l'une des revendications 9 à 11, dans lequel la rondelle autobloquante (5) entre en contact avec un (ou des) fil(s) électrique(s) et/ou câble(s) (6), ledit (ou lesdits) fil(s) électrique(s) et/ou câble(s) (6) étant maintenu(s) fixement à l'intérieur du passage (41) par la rondelle autobloquante (5).

## Patentansprüche

1. Gehäuse (B) eines intelligenten Zählers, umfassend einen Träger (1) und eine Vorrichtung (10) zum Blockieren mindestens eines elektrischen Drahts und/oder mindestens eines Kabels (6) an dem Träger (1), der umfasst:
- eine Basis (2), die mit dem Träger (1) fest verbunden ist,
- einen Butzen (3), der von der Basis (2) aus vorsteht,
- mindestens eine Wand (4), die von der Basis (2) aus vorsteht und sich gegenüber diesem Butzen (3) erstreckt,
wobei der Träger (1), die Basis (2), der Butzen (3) und die Wand (4) aus einem Stück mit mindestens einer Wand des Gehäuses (B) gegossen sind, und die Basis (2), der Butzen (3) und die Wand (4) zwischen sich einen Durchgang (41) begrenzen, der dazu geeignet ist, von einem oder mehreren zu blockierenden elektrischen Drähten und/oder Kabeln (6) durchquert zu werden;
- eine selbstsichernde Unterlegscheibe (5) mit Krallen (52), die dazu angepasst ist, an dem Butzen (3) in Eingriff zu kommen und sich mechanisch zwischen dem Butzen (3) und der oder den Wänden (4) zu blockieren, um im Verhältnis zur Basis (2) und zum Träger (1) einen oder mehrere elektrische Drähte und/oder Kabel (6), die zuvor in dem Durchgang (41) positioniert wurden, festzuhalten.

2. Gehäuse (B) eines intelligenten Zählers nach Anspruch 1, wobei die Krallen (52) der selbstsichernden Unterlegscheibe (5) interne Krallen (52) sind, die dazu angepasst sind, sich an dem Butzen (3) zu verankern.

3. Gehäuse (B) eines intelligenten Zählers nach einem der Ansprüche 1 bis 2, wobei die Krallen (52) der selbstsichernden Unterlegscheibe (5) in einer Kegelstumpfform gestaltet sind, die eine Vorpositionierung der selbstsichernden Unterlegscheibe (5) an dem Butzen (3) erleichtert.

4. Gehäuse (B) eines intelligenten Zählers nach einem der Ansprüche 1 bis 3, wobei der Butzen (3) eine Abschrägung (31) umfasst, um die Vorpositionierung der selbstsichernden Unterlegscheibe (5) an dem Butzen (3) zu erleichtern.

5. Gehäuse (B) eines intelligenten Zählers nach einem der Ansprüche 1 bis 4, wobei eine Wand (4) eine Oberfläche (42) gegenüber dem Butzen (3) aufweist, die eine ergänzende Form und ergänzende Abmessungen zu denen der selbstsichernden Unterlegscheibe (5) aufweist, wobei die Wand (42) zur Führung und Halterung der selbstsichernden Unterlegscheibe (5) beiträgt.

6. Gehäuse (B) eines intelligenten Zählers nach einem der Ansprüche 1 bis 5, wobei sich mehrere Wände (4) von der Basis (2) aus vorstehend erstrecken, wobei die Wände (4) jeweils zwischen sich und dem Butzen (3) einen Durchgang (41) begrenzen, der dazu geeignet ist, von einem oder mehreren elektrischen Drähten und/oder Kabeln (6) durchquert zu werden.

7. Gehäuse (B) eines intelligenten Zählers nach einem der Ansprüche 1 bis 6, wobei der Butzen (3) eine hohle Form aufweist.

8. Gehäuse (B) eines intelligenten Zählers nach einem der Ansprüche 1 bis 7, wobei die Wand des Gehäuses eine Basis (2) für die Vorrichtung (10) bildet.

9. Verfahren zum Blockieren mindestens eines elektrischer Drahts und/oder mindestens eines Kabels (6) an einem Träger (1) des Gehäuses (B) nach einem der Ansprüche 1 bis 8, wobei das Verfahren folgende Schritte umfasst:
- (E1) Einfügen mindestens eines elektrischer Drahts und/oder mindestens eines Kabels (6) in einen Durchgang (41), der durch die Basis (2), den Butzen (3) und eine Wand (4) der Vorrichtung definiert wird;
- (E2) Vorpositionieren der selbstsichernden Unterlegscheibe (5) an dem Butzen (3);
- (E3) In-Eingriff-Bringen der selbstsichernden Unterlegscheibe (5) an dem Butzen (3) bis in eine Blockierungsposition.

10. Verfahren zum Blockieren nach Anspruch 9, wobei das In-Eingriff-Bringen der selbstsichernden Unterlegscheibe (5) in der Blockierungsposition anhand eines Einfügewerkzeugs (7) erfolgt, das dazu angepasst ist, das selbstsichernde Element auf den Butzen (3) zu schieben.

11. Verfahren zum Blockieren nach Anspruch 10, wobei das Einfügewerkzeug (7) eine Verkleidung umfasst, deren Ränder das Schieben der selbstsichernden Unterlegscheibe (5) sicherstellen, wenn sie an dem Butzen (3) in Eingriff gebracht wird, und einen Hohlraum (71) mit einem Boden (72) definiert, der dazu angepasst ist, an dem Ende des Butzens (3), das der Basis (2) gegenüberliegt, zur Anlage zu kommen, wobei die Höhe des Bodens (72) in der Verkleidung (70) derart dimensioniert ist, dass die Blockierungsposition, in welche die selbstsichernde Unterlegscheibe (5) geschoben wird, einen oder mehrere elektrische Drähte und/oder Kabel (6) zum Gleiten mit einem Freiheitsgrad im Innern des Durchgangs (41) frei lässt, wobei der Boden (72) an dem Butzen (3) zur Anlage kommt, bevor die selbstsichernde Unterlegscheibe (5) mit dem oder den Drähten und/oder Kabeln in Kontakt kommt.

12. Verfahren zum Blockieren nach einem der Ansprüche 9 bis 11, wobei die selbstsichernde Unterlegscheibe (5) mit einem oder mehreren elektrischen Drähten und/oder Kabeln (6) in Kontakt kommt, wobei das eine oder die mehreren elektrischen Drähte und/oder Kabel (6) im Innern des Durchgangs (41) durch die selbstsichernde Unterlegscheibe (5) fest gehalten werden.

## Claims

1. A communicating meter box (B) comprising a support (1) and a device (10) for locking at least one electric wire and/or at least one cable (6) on the support (1), which comprises:
- a base (2) secured to the support (1),
- a pin (3) protruding from the base (2),
- at least one wall (4) protruding from the base (2) and extending facing this pin (3),
- the support (1), the base (2), the pin (3) and the wall (4) being molded as one part with at least one wall of said box (B), and the base (2), the pin (3) and the wall (4) together delimiting a passage (41) intended to be traversed by one or more electric wires and/or cables (6) to be locked;
- a self-locking washer (5) with claws (52) suitable for engaging itself on the pin (3) and mechanically locking itself between the pin (3) and the wall (or walls) (4) in order to retain, with respect to the base (2) and to the support (1), one or more electric wires and/or cables (6) previously positioned in the passage (41).

2. A communicating meter box (B) as claimed in claim 1, wherein the claws (52) of the self-locking washer (5) are inner claws (52) suitable for anchoring themselves onto the pin (3).

3. The communicating meter box (B) as claimed in one of claims 1 to 2, wherein the claws (52) of the self-locking washer (5) are shaped into a frustoconical shape, which facilitates the pre-positioning of said self-locking washer (5) on the pin (3).

4. The communicating meter box (B) as claimed in one of claims 1 to 3, wherein the pin (3) comprises a chamfer (31) to facilitate the pre-positioning of the self-locking washer (5) on the pin (3).

5. The communicating meter box (B) as claimed in one of claims 1 to 4, wherein a wall (4) has a surface (42) facing the pin (3) which is of a shape and dimensions complementary to those of the self-locking washer (5), said wall (42) participating in the guiding and holding of the self-locking washer (5).

6. The communicating meter box (B) as claimed in one of claims 1 to 5, wherein several walls (4) protrude from the base (2), said walls (4) each delimiting, between itself and the pin (3), a passage (41) intended to be traversed by one or more electric wires and/or cables (6).

7. The communicating meter box (B) as claimed in one of claims 1 to 6, wherein the pin (3) is hollow in shape.

8. The communicating meter box (B) as claimed in any of claims 1 to 7, wherein said wall of the box constituting a base (2) for the device (10).

9. A locking method for at least one electric wire and/or at least one cable (6) on a box (B) support (1) as claimed in one of claims 1 to 8, the method comprising the following steps:
- (E1) inserting at least one electric wire and/or at least one cable (6) into a passage (41) defined by the base (2), the pin (3) and a wall (4) of the device;
- (E2) pre-positioning the self-locking washer (5) on the pin (3);
- (E3) engaging the self-locking washer (5) on the pin (3) all the way into a locking position.

10. The locking method as claimed in claim 9, wherein the engaging of the self-locking washer (5) in the locking position is done by means of an inserting tool (7) suitable for pushing the self-locking element onto the pin (3).

11. The locking method as claimed in claim 10, wherein the inserting tool (7) comprises a skirt, the edges of which ensure the pushing of the self-locking washer (5) during its engagement on the pin (3) and, defining a cavity (71) with a bottom (72) suitable for abutting against the end of the pin (3) opposite the base (2), the height of said bottom (72) in said skirt (70) being dimensioned in such a way that the locking position into which the self-locking washer (5) is pushed leaves one or more electric wires and/or cables (6) free to slide with one degree of freedom inside the passage (41), said bottom (72) then abutting the pin (3) before the self-locking washer (5) comes into contact with the wire(s) and/or cable(s).

12. The locking method as claimed in one of claims 9 to 11, wherein the self-locking washer (5) comes into contact with one or more electric wires and/or cables (6), said electric wire(s) and/or cable(s) (6) being held fixedly inside the passage (41) by the self-locking washer (5).
